# EUROPÄISCHE PATENTANMELDUNG

(11) **EP 3 718 678 A1**
(43) Veröffentlichungstag der Anmeldung: **07.10.2020**
(21) Anmeldenummer: 19167071.0
(22) Anmeldetag: 03.04.2019
(51) Int. Cl.: B23K 35/26, B23K 35/02, C30B 11/00, C22C 12/00, C22C 13/00, C30B 29/52, B23K 35/40, C22C 13/02, B23K 35/36

(54) **VERFAHREN ZUR HERSTELLUNG EINES SNBI-LÖTDRAHTES, LÖTDRAHT UND VORRICHTUNG**

(71) Anmelder: Felder GmbH Löttechnik, 46047 Oberthausen (DE)
(72) Erfinder: Probst, Michael, 45147 Essen (DE)
(74) Vertreter: Michalski Hüttermann & Partner Patentanwälte mbB

(57) **Zusammenfassung**

Die vorliegende Erfindung betrifft ein Verfahren zur Herstellung eines ziehfähigen Lötdrahtes, insbesondere eines SnBi-Lötdrahtes, wobei das Verfahren die folgenden Schritte aufweist: Bereitstellen einer Lot-Legierung, Ausbilden eines im Wesentlichen einkristallinen Bolzens aus der Lot-Legierung, wobei die Lot-Legierung zumindest teilweise geschmolzen und wieder kristallisiert wird, und Ausbilden eines Lötdrahtes aus dem im Wesentlichen einkristallinen Bolzen. Die vorliegende Erfindung betrifft zudem einen ziehfähigen Lötdraht, insbesondere einen SnBi-Lötdraht, sowie eine Vorrichtung zur Herstellung eines ziehfähigen Lötdrahtes, insbesondere eines SnBi-Lötdrahtes.

## Beschreibung

Die vorliegende Erfindung betrifft ein Verfahren zur Herstellung eines ziehfähigen Lötdrahtes, insbesondere eines ziehfähigen SnBi-Lötdrahts, einen ziehfähigen Lötdraht, insbesondere einen ziehfähigen SnBi-Lötdraht und eine Vorrichtung zur Herstellung eines ziehfähigen Lötdrahts.

In der Elektrotechnik und der Elektronikindustrie gehört das Löten (Fügen) zu den wichtigsten Verbindungstechniken. Lötlegierungen werden als stoffschlüssige Verbindungen zwischen Metallen und Keramiken eingesetzt, wo ein Aufschmelzen des Grundwerkstoffes nicht möglich oder unvorteilhaft ist.

Grundsätzlich wurden in der Vergangenheit in der Aufbau- und Verbindungstechnik für elektronische Produkte weltweit Zinn-Blei-Lote eingesetzt. Seit Juli 2006 ist auf Grund der EU-Richtlinie RoHS (Novellierung seit Mitte 2011) der Einsatz von bleihaltigen Loten generell verboten und nur noch in Ausnahmefällen zulässig. Der Umstieg auf bleifreie Lote beschränkt sich nicht nur auf die EU, sondern er wurde global durchgeführt.

Lotlegierungen auf Zinn-Bismut-Basis sind an sich bekannt und finden als bleifreie Legierung wegen ihrer geringen Schmelztemperaturen aber dennoch hohen Festigkeiten einen erhöhten Einsatz in der Elektronik. Im Vergleich zu anderen bleifreien Legierungen wie den Zinn-Silber, Zinn-Kupfer oder Zinn-Silber-Kupferloten können die Zinn-Bismut-Legierungen jedoch nicht nach herkömmlichen Verfahren in Stranggussanlagen hergestellt werden, da sich auf Grund einer Dichteanomalie die Legierung beim Abkühlen ausdehnt und somit der Strang abreißen würde. Zudem sind Zinn-Bismut-Legierungen wenig duktil, was die Herstellung von dünnen Massivdrähten oder flussmittelgefüllten Drähten nahezu unmöglich macht, da diese Verfahren ein Kaltumformen und insbesondere ein Ziehen der Legierung bedürfen.

Es ist daher die Aufgabe der vorliegenden Erfindung, ein Verfahren zur Herstellung von ziehfähigen Lötdrähten, insbesondere von ziehfähigen SnBi-Lötdrähten bereitzustellen.

Unter ziehfähigen Lötdrähten, insbesondere SnBi-Lötdrähten sind im Rahmen der vorliegenden Erfindung Lötdrähte mit verbesserten Kaltumformungseigenschaften zu verstehen.

Gelöst wird diese Aufgabe durch ein Verfahren gemäß Anspruch 1, sowie ferner durch den Lötdraht nach Anspruch 11 und die Vorrichtung nach Anspruch 14. Bevorzugte Ausgestaltungen der Erfindung sind in den Unteransprüchen, in der Beschreibung oder den Figuren angegeben, wobei weitere in den Unteransprüchen oder in der Beschreibung oder den Figuren beschriebene oder gezeigte Merkmale einzeln oder in einer beliebigen Kombination einen Gegenstand der Erfindung darstellen können, wenn sich aus dem Kontext nicht eindeutig das Gegenteil ergibt.

Mit der Erfindung wird ein Verfahren zur Herstellung eines ziehfähigen Lötdrahtes, insbesondere eines SnBi-Lötdrahtes vorgeschlagen.

Das Verfahren weist dabei die folgenden Schritte auf:
a. Bereitstellen einer Lot-Legierung, insbesondere einer SnBi-Legierung
b. Ausbilden eines im Wesentlichen einkristallinen Bolzens aus der Lot-Legierung, wobei die Lot-Legierung zumindest teilweise geschmolzen und wieder kristallisiert wird
c. Ausbilden eines Lötdrahtes aus dem im Wesentlichen einkristallinen Bolzen.

Es konnte in überraschender Weise gezeigt werden, dass durch ein derartiges Verfahren ein ziehfähiger Lötdraht, insbesondere ein SnBi-Lötdraht, also ein SnBi-Lötdraht mit verbesserten Kaltumformungseigenschaften erreicht werden kann. Dadurch kann erreicht werden, dass Bolzen und Drähte aus der Legierung, insbesondere der SnBi-Legierung eine verbesserte Verarbeitbarkeit aufweisen. Mit dem erfindungsgemäßen Verfahren kann erreicht werden, dass Kaltumformungen, insbesondere ein Ziehen des Lötdrahtes, reproduzierbar und maschinell durchgeführt werden können, ohne dass das Material übermäßig häufig reißt.

Unter dem Begriff "SnBi-Legierung" ist im Sinne der Erfindung eine Legierung aufweisend die Hauptbestandteile Zinn und Bismut zu verstehen.

Unter dem Begriff "im Wesentlichen einkristalliner Bolzen" ist im Sinne der Erfindung ein kristalliner Bolzen zu verstehen, der im Wesentlichen aus einem einzigen makroskopischen Kristall besteht. In anderen Worten ist darunter zu verstehen, dass der Bolzen im Wesentlichen keine Korngrenzen innerhalb des Bolzens aufweist. Dabei kann der Bolzen Defekte wie Leerstellen oder Versetzungen aufweisen, sowie eine Mosaikstruktur. Insbesondere sind unter "im Wesentlichen einkristallinen Bolzen" keine polykristallinen Bolzen zu verstehen. Bevorzugt ist der im Wesentlichen einkristalline Bolzen ein einkristalliner Bolzen.

Grundsätzlich ist das erfindungsgemäße Verfahren auch zur Herstellung von Lötdrähten aus andern Legierungen geeignet, welche aufgrund sich üblicher Weise in den Legierungen ausbildender Mischkristallphasen nur schwer ziehbar sind.

In einer Ausgestaltung der Erfindung kann vorgesehen sein, dass die SnBi-Legierung bezogen auf die Masse der SnBi-Legierung besteht aus:
- Bismut in einem Bereich von ≥ 31 gew.-% bis ≤ 59 gew.-%, vorzugsweise ≥ 57 gew.-% bis ≤ 59 gew.-%,
- optional einem Minderelementzusatz ausgewählt aus der Gruppe bestehend aus Silber, Kupfer, Zink, Nickel, Germanium und Mischungen davon in einem Bereich von ≥ 0 gew.-% bis ≤ 3,5 gew.-%, vorzugsweise ≥ 0 gew.-% bis ≤ 1,5 gew.-%, insbesondere ≥ 0,3 gew.-% bis ≤ 1,1 gew.-%,
- und dem Rest Zinn.

Dadurch kann vorteilhafter Weise ein niedriger Schmelzpunkt der Legierung erreicht werden, sowie eine glänzende und oxidbeständige Oberfläche des ausgebildeten Lötdrahtes, wobei die gute Verarbeitbarkeit erhalten bleibt.

In einer bevorzugten Ausgestaltung der Erfindung kann vorgesehen sein, dass die SnBi-Legierung bezogen auf die Masse der SnBi-Legierung besteht aus:
- Bismut in einem Bereich von ≥ 57 gew.-% bis ≤ 59 gew.-%,
- und dem Rest Zinn.

In einer alternativen bevorzugten Ausgestaltung der Erfindung kann vorgesehen sein, dass die SnBi-Legierung bezogen auf die Masse der SnBi-Legierung besteht aus:
- Bismut in einem Bereich von ≥ 57 gew.-% bis ≤ 59 gew.-%,
- Silber in einem Bereich von ≥ 0 gew.-% bis ≤ 1 gew.-%, vorzugsweise ≥ 0.3 gew.-% bis ≤ 1 gew.-%, insbesondere ≥ 0,35 gew.-% bis ≤ 0,45 gew.-%,
- und dem Rest Zinn.

In einer weiteren alternativen bevorzugten Ausgestaltung der Erfindung kann vorgesehen sein, dass die SnBi-Legierung bezogen auf die Masse der SnBi-Legierung besteht aus:
- Bismut in einem Bereich von ≥ 56 gew.-% bis ≤ 59 gew.-%,
- Silber in einem Bereich von ≥ 0,45 gew.-% bis ≤ 0,55 gew.-%, Kupfer in einem Bereich von ≥ 0,45 gew.-% bis ≤ 0,55 gew.-%, Nickel in einem Bereich von ≥ 0,04 gew.-% bis ≤ 0,08 gew.-% und Germanium in einem Bereich von ≥ 0,01 gew.-% bis ≤ 0,02 gew.-%,
- und dem Rest Zinn.

In einer weiteren alternativen bevorzugten Ausgestaltung der Erfindung kann vorgesehen sein, dass die SnBi-Legierung bezogen auf die Masse der SnBi-Legierung besteht aus:
- Bismut in einem Bereich von ≥ 31 gew.-% bis ≤ 32 gew.-%,
- Zink in einem Bereich von ≥ 2,5 gew.-% bis ≤ 3,5 gew.-%,
- und dem Rest Zinn.

In einer Ausgestaltung der Erfindung kann vorgesehen sein, dass das Ausbilden des Lötdrahtes ein Kaltumformen des Bolzens, insbesondere ein Pressen des Bolzens durch eine Matrize, zu einem Lötdraht umfasst.

Dadurch kann vorteilhafter Weise erreicht werden, dass der Bolzen zu einem Lötdraht geformt wird, ohne die Ziehfähigkeit des Lotmaterials zu stark zu beeinflussen.

In einer Ausgestaltung der Erfindung kann vorgesehen sein, dass das Kaltumformen des Bolzens, insbesondere das Pressen des Bolzens durch eine Matrize, das Bereitstellen eines Flussmittels und das Ausbilden von einem Lötdraht aufweisend zumindest eine Flussmittelseele umfasst.

Dadurch kann vorteilhafter Weise erreicht werden, dass aus dem Bolzen Lötdrähte mit Flussmittelseele herstellbar sind, ohne die Ziehfähigkeit des Lotmaterials zu stark zu beeinflussen.

Unter einer "Flussmittelseele" ist im Rahmen der vorliegenden Erfindung der Einschluss eines Flussmittels in den Querschnitt des Lötdrahtes zu verstehen. Dabei kann der Lötdraht eine Flussmittelseele, beispielsweise in der Mitte des Querschnitts des Lötdrahtes aufweisen oder mehrere, voneinander getrennte Flussmittelseelen.

Unter einem "Flussmittel" ist im Rahmen der vorliegenden Erfindung eine Zusammensetzung zu verstehen, durch die eine Benetzung des Werkstückes durch das Lot verbessert wird und die vorzugsweise insbesondere Oxide entfernt und eine Grenzflächenspannung herabsetzt.

In einer Ausgestaltung der Erfindung kann vorgesehen sein, dass das Pressen des Bolzens bei einer Presskammertemperatur in einem Bereich von größer oder gleich 65°C bis kleiner oder gleich 100°C, vorzugsweise in einem Bereich von größer oder gleich 70°C bis kleiner oder gleich 90°C, beispielsweise bei 75°C durchgeführt wird.

Dadurch kann vorteilhafter Weise erreicht werden, dass sich der Bolzen besonders einfach pressen lässt.

In einer Ausgestaltung der Erfindung kann vorgesehen sein, dass das Pressen des Bolzens mit einer Bolzengeschwindigkeit in einem Bereich von größer oder gleich 0,2 mm/s bis kleiner oder gleich 0,4 mm/s, beispielsweise von 0,3 mm/s gestartet wird und die Bolzengeschwindigkeit beim Pressen des Bolzens auf eine Bolzengeschwindigkeit in einen Bereich von größer oder gleich 0,5 mm/s bis kleiner oder gleich 0,7 mm/s, beispielsweise von 0,6 mm/s angehoben wird.

Dadurch kann vorteilhafter Weise ein guter Durchsatz erreicht werden, ohne die Qualität des Lötdrahtes zu beeinträchtigen.

In einer Ausgestaltung der Erfindung kann vorgesehen sein, dass eine Flussmittelvorlage beim Pressen des Bolzens auf einer Vorwärmtemperatur in einem Bereich von größer oder gleich 125°C bis kleiner oder gleich 135°C, vorzugsweise in einem Bereich von größer oder gleich 128°C bis kleiner oder gleich 129°C gehalten wird. Insbesondere kann vorgesehen sein, dass die Flussmittelvorlage beim Pressen des Bolzens auf einer Vorwärmtemperatur gehalten wird, die kleiner oder gleich einer Temperatur ist, die zumindest 10°C niedriger als die Schmelztemperatur des SnBi-Lotes ist. Zudem kann vorgesehen sein, dass die Flussmittelvorlage in einem Behälter bei einem Druck im Bereich von größer oder gleich 1,8 bar bis kleiner oder gleich 2,4 bar, vorzugsweise in einem Bereich von größer oder gleich 2,0 bar bis kleiner oder gleich 2,2 bar gehalten wird.
Dadurch kann vorteilhafter Weise erreicht werden, dass das Flussmittel gut verarbeitbar ist, ohne die SnBi-Legierung durch Hitze zu stark zu beeinflussen.

Durch die vorbeschriebenen Verfahrensparameter für das Pressen des Bolzens können besonders gut Lötdrähte mit gleichbleibender Qualität und gutem Durchsatz hergestellt werden.

In einer Ausgestaltung der Erfindung kann vorgesehen sein, dass das Flussmittel ausgewählt ist aus der Gruppe bestehend aus Kolophoniumharz, hydriertes Kolophoniumharz, modifizierte Kolophoniumharz, Harnstoff und nichtionische ethoxylierte oder propylierte Alkohole mit einem Schmelzpunkt ≥40°C sowie Mischungen der zuvor genannten.

Dadurch kann vorteilhafter Weise erreicht werden, dass eine gleichmäßige und durchgehende Haftung des Lötzinns an der zu verlötenden Oberfläche erreicht wird. Insbesondere Kolophoniumharze, aber auch Harnstoff, wirkend dabei im Lötprozess aktivierend und können so etwaige Oxidschichten an den Lötoberflächen aufbrachen, um im Zuge der sogenannten Eigenaktivierung eine bessere intermetallische Verbindung zwischen Lötzinn und Lötoberfläche sicherzustellen. Dabei haben insbesondere Harze den Vorteil, dass sie nach dem Lötprozess wieder erstarren und eine weitere oxidative Wirkung mehr entfalten, wodurch die Notwenigkeit zur Reinigung der gelöteten Oberflächen verringert wird.

In einer Ausgestaltung der Erfindung kann vorgesehen sein, dass das Ausbilden des Lötdrahtes ein Ziehen zu einem Lötdraht umfasst. Insbesondere kann vorgesehen sein, dass das Ausbilden des Lötdrahtes nach dem Pressen des Bolzens ein Ziehen des Lötdrahtes umfasst.

Dadurch kann vorteilhafter Weise ein Durchmesser des Lötdrahtes eingestellt werden. Insbesondere können durch ein Ziehen besonders dünne Durchmesser erreicht werden. Dabei können auch dünne, flussmittelgefüllte Lötdrähte erhalten werden.

In einer Ausgestaltung der Erfindung kann vorgesehen sein, dass der Lötdraht beim Ziehen des Lötdrahtes in einem Schmiermittel, beispielsweise Öl, bei einer Temperatur in einem Bereich von größer oder gleich 60°C bis kleiner oder gleich 80°C, vorzugsweise in einem Bereich von größer oder gleich 65°C bis kleiner oder gleich 75°C, beispielsweise bei einer Temperatur von 70°C, einmal oder mehrmals über einen Ziehstein gezogen wird.

Dadurch kann vorteilhafter Weise erreicht werden, dass der Lötdraht besonders schonend gezogen wird.

In einer Ausgestaltung der Erfindung kann vorgesehen sein, dass nach dem Ausbilden des Lötdrahtes der Lötdraht auf eine Spule gespult wird.

Dadurch kann vorteilhafter Weise erreicht werden, dass der Lötdraht gut gelagert, transportiert und verwendet werden.

In einer Ausgestaltung der Erfindung kann vorgesehen sein, dass der Lötdraht mehrere Male gezogen wird. Dabei kann vorgesehen sein, dass nach jedem Ziehen der Lötdraht aufgespult wird und bei erhöhter Temperatur gelagert wird, bevor das nächste Ziehen durchgeführt wird.

In einer Ausgestaltung der Erfindung kann vorgesehen sein, dass der Lötdraht nach dem Ziehen noch einmal über einen Ziehstein mit gleichem Durchmesser wie der Lötdraht ohne Schmiermittel geführt wird.

Dadurch kann vorteilhafter Weise restliches Schmiermittel von der Oberfläche des Lötdrahtes entfernt werden, ohne den Lötdraht durch weiteres Ziehen zu zerreißen.

In einer Ausgestaltung der Erfindung kann vorgesehen sein, dass das Ausbilden des im Wesentlichen einkristallinen Bolzens ein vollständiges Aufschmelzen der SnBi-Legierung zu einer Schmelze umfasst und der im Wesentlichen einkristalline Bolzen durch Kristallisation der Schmelze ausgebildet wird.

Dadurch kann vorteilhafter Weise ein im Wesentlichen einkristalliner Bolzen mit einfacher Prozessführung hergestellt werden.

In einer Ausgestaltung der Erfindung kann dabei vorgesehen sein, dass die Schmelze in einem Tiegel vorliegt, wobei der Tiegel einen zylindrischen Wachstumsbereich aufweist und der Tiegel an einem Ende des zylindrischen Wachstumsbereiches einen verjüngten Keimbereich aufweist, wobei in einem ersten Schritt die Schmelze im Keimbereich unter die Schmelztemperatur gebracht wird, wobei ein Kristallisationskeim im Keimbereich ausgebildet wird, und in einem zweiten Schritt der Wachstumsbereich graduell ausgehend vom Keimbereich unter die Schmelztemperatur gebracht wird, wobei der Kristallisationskeim in den Wachstumsbereich wächst und den im Wesentlichen einkristallinen Bolzen ausbildet. Insbesondere kann in einer Ausgestaltung der Erfindung vorgesehen sein, dass der im Wesentlichen einkristalline Bolzen durch das Bridgman-Verfahren ausgebildet wird.

Dadurch kann vorteilhafter Weise erreicht werden, dass der im Wesentlichen einkristalline Bolzen mit einfacher Prozessführung hergestellt werden kann.

Unter dem Bridgman-Verfahren wird im Rahmen der vorliegenden Erfindung das Verfahren zum Ziehen großer Einkristalle nach Bridgman verstanden, welches auch unter dem Namen Bridgman-Stockbarger-Methode bekannt ist.

In einer Ausgestaltung der Erfindung kann vorgesehen sein, dass der Tiegel im Wesentlichen aus einem Quarzglas oder einem Borosilikatglas besteht.

In einer Ausgestaltung der Erfindung kann vorgesehen sein, dass der Tiegel in einem ersten Schritt in einem Ofen auf eine Temperatur in einem Bereich von größer oder gleich 155°C bis kleiner oder gleich 175°C, vorzugsweise von größer oder gleich 160°C bis kleiner oder gleich 170°C, beispielsweise von 165°C, gebracht wird, in einem zweiten Schritt die Schmelze in den Tiegel gefüllt wird, und in einem dritten Schritt der Tiegel langsam mit steigender Geschwindigkeit mit dem Keimbereich voran aus dem Ofen gefahren wird.

Dadurch kann vorteilhafter Weise eine besonders gute Reproduzierbarkeit des Verfahrens erreicht werden.

In einer Ausgestaltung der Erfindung kann vorgesehen sein, dass die SnBi-Legierung als Bolzen bereitgestellt wird und das Ausbilden des im Wesentlichen einkristallinen Bolzens ein Zonenschmelzen des Bolzens unter Ausbildung des im Wesentlichen einkristallinen Bolzens umfasst.

In einer Ausgestaltung der Erfindung kann vorgesehen sein, dass beim Zonenschmelzen der Bolzen entlang seiner Längsachse relativ zu einer den Bolzen orthogonal zur Längsrichtung umgebenen ringförmigen Heizvorrichtung bewegt wird, wobei der Bolzen in einer durch die ringförmige Heizvorrichtung umgebenen Schmelzzone zumindest teilweise geschmolzen wird und durch relative Bewegung zur Heizvorrichtung außerhalb der Schmelzzone unter Ausbildung des im Wesentlichen einkristallinen Bolzens wieder kristallisiert wird.

Dadurch kann vorteilhafter Weise erreicht werden, dass der im Wesentlichen einkristalline Bolzen besonders wenige Lufteinschlüsse aufweist. Zudem kann dadurch erreicht werden, dass der Bolzen keine Verjüngung oder dergleichen aufweist.

In einer Ausgestaltung der Erfindung kann vorgesehen sein, dass der Bolzen von einer temperaturbeständigen Ummantelung umgeben ist, wobei die Ummantelung vorzugsweise eine innere temperaturbeständige Silikonschicht und eine äußere Glasschicht umfasst.

Dadurch kann vorteilhafter Weise erreicht werden, dass der Bolzen in der Schmelzzone nicht zerfließt und der Bolzen nach dem Zonenschmelzen von der Ummantelung abtrennbar ist.

In einer Ausgestaltung der Erfindung kann vorgesehen sein, dass der im Wesentlichen einkristalline Bolzen nach dem Zonenschmelzen mit Wasser und oder Druckluft von der Ummantelung getrennt wird.

Dabei kann vorgesehen sein, dass die Glasschicht beliebig oft wiederverwendet wird und die Silikonschicht zumindest mehr als einmal wiederverwendet wird.

In einer Ausgestaltung der Erfindung kann vorgesehen sein, dass der Bolzen beim Zonenschmelzen zusätzlich gekühlt wird. Dabei kann vorgesehen sein, dass der Bolzen an zumindest einem Ende in Längsrichtung mit einem Kühlelement kontaktiert wird. In einer bevorzugten Ausgestaltung der Erfindung kann vorgesehen sein, dass der Bolzen an dem Ende mit einem Kühlelement kontaktiert wird, an dem das Zonenschmelzen begonnen wird, d.h. an dem Ende von dem die ringförmige Heizvorrichtung relativ zum Bolzen wegbewegt wird.

Dadurch kann vorteilhafter Weise erreicht werden, dass der zumindest teilweise geschmolzene Bolzen nach dem Verlassen der Schmelzzone wieder kristallisiert.

In einer Ausgestaltung der Erfindung kann vorgesehen sein, dass die ringförmige Heizvorrichtung eine mit Wechselstrom betriebene Induktionsspule umfasst, wobei die Induktionsspule vorzugsweise mit einem Wechselstrom mit einer Frequenz im Bereich von größer oder gleich 250 kHz bis kleiner oder gleich 350 kHz, vorzugsweise von größer oder gleich 280 kHz bis kleiner oder gleich 320 kHz, beispielsweise 300 kHz, betrieben wird.

Dadurch kann vorteilhafter Weise erreicht werden, dass die Legierung des Bolzens gezielt angeregt wird. Dadurch kann die Leistung der Induktionsspule geringgehalten werden und das Heizen kann besonders gut kontrolliert werden.

In einer Ausgestaltung der Erfindung kann vorgesehen sein, dass der Bolzen entlang seiner Längsachse mit einer Geschwindigkeit in einem Bereich von ≥3mm/min bis ≤10mm/min relativ zur ringförmigen Heizvorrichtung bewegt wird. Dabei kann es insbesondere vorgesehen sein, dass die Relativgeschwindigkeit zwischen Bolzen und Heizvorrichtung in Bewegungsrichtung zunimmt, mithin das Verfahren mit einer ersten Relativgeschwindigkeit a startet und im Laufe des Verfahrens auf einen Relativgeschwindigkeit b ansteigt, wobei a<b ist. Insbesondere kann es dabei vorgesehen sein, dass der Anstieg der Relativgeschwindigkeit nicht linear erfolgt, insbesondere progressiv erfolgt.

Dadurch kann vorteilhafter Weise erreicht werden, dass der im Wesentlichen einkristalline Bolzen möglichst schnell gebildet wird, ohne die Qualität des Bolzens im Wesentlichen zu beeinträchtigen. Insbesondere kann dadurch erreicht werden, dass sich die Schmelzzone vollständig ausbildet, aber nicht übermäßig lange besteht.

Insbesondere kann vorgesehen sein, dass die Relativgeschwindigkeit zwischen Heizvorrichtung und Bolzen während des Aufschmelzens variiert wird. Dabei kann es weiter vorgesehen sein, dass die Relativgeschwindigkeit im Laufe des Verfahrens von einem ersten niedrigeren Wert auf einen zweiten höheren Wert erhöht wird. Die Erhöhung kann dabei beispielsweise um einen Faktor ≤ 3, vorzugsweise ≤ 3 erfolgen, wobei sowohl eine lineare Erhöhung als auch eine nichtlineare Erhöhung der Relativgeschwindigkeit vorgesehen seien kann. Durch die Variation der Relativgeschwindigkeit kann dabei vorteilhafter Weise ein optimiertes Aufschmelzen des Bolzen erreicht werden.

Mit der Erfindung wird weiterhin ein ziehfähiger Lötdraht, insbesondere ein ziehfähiger SnBi-Lötdraht vorgeschlagen.

Im Detail ist vorgesehen, dass der ziehfähige Lötdraht nach dem vorbeschriebenen Verfahren hergestellt ist.

Dadurch kann vorteilhafter Weise erreicht werden, dass der Lötdraht besonders dünn oder mit einer Flussmittelseele ausgestaltet sein kann.

In einer Ausgestaltung der Erfindung kann vorgesehen sein, dass der ziehfähige Lötdraht, insbesondere der ziehfähige SnBi-Lötdraht zumindest eine Flussmittelseele aufweist. Dadurch kann vorteilhafter Weise erreicht werden, dass beim Löten kein zusätzliches Flussmittel hinzugegeben werden muss und dass die Flussmittelzufuhr beim Löten besonders konstant gehalten werden kann.

In einer Ausgestaltung der Erfindung kann vorgesehen sein, dass der ziehfähige SnBi-Lötdraht einen Durchmesser aufweist in einem Bereich von kleiner oder gleich 1,5 mm bis größer oder gleich 0,2 mm, vorzugsweise von kleiner oder gleich 1,0 mm bis größer oder gleich 0,4 mm, besonders bevorzugt von kleiner oder gleich 0,8 mm bis größer oder gleich 0,5 mm.

Dadurch kann vorteilhafter Weise erreicht werden, dass auch feine Verbindungen mit dem Lötdraht gelötet werden können. Darüber hinaus ist es aufgrund der höheren Duktilität der so hergestellten Lötdrähte auch möglich Formteile, wie beispielsweise Lötringe herzustellen.

Mit der Erfindung wird weiterhin eine Vorrichtung zur Herstellung eines ziehfähigen Lötdrahtes, insbesondere eines SnBi-Lötdrahts vorgeschlagen.

Im Detail ist vorgesehen, dass die Vorrichtung zur Durchführung des vorbeschriebenen Verfahrens ausgestaltet ist, wobei die Vorrichtung eine Kristallisiervorrichtung und eine Verformungsvorrichtung aufweist.

In einer bevorzugten Ausgestaltung der Erfindung kann vorgesehen sein, dass die Kristallisiervorrichtung zur Durchführung eines Zonenschmelzverfahrens ausgestaltet ist.

In einer Ausgestaltung der Erfindung kann vorgesehen sein, dass die Kristallisiervorrichtung ein ringförmiges Heizelement, ein Kühlelement, einen Generator und einen Antrieb aufweist. Dabei kann in einer Ausgestaltung der Erfindung vorgesehen sein, dass das ringförmige Heizelement einen inneren Durchmesser aufweist, der größer ist als der Durchmesser eines zu kristallisierenden Bolzens.

Dadurch kann erreicht werden, dass der Bolzen relativ zum Heizelement bewegbar ist und dabei von dem Heizelement orthogonal zu einer Längsrichtung des Bolzens umgeben werden kann. In einer vorteilhaften Ausgestaltung der Erfindung kann vorgesehen sein, dass das ringförmige Heizelement eine Induktionsspule ist, vorzugsweise eine Hochfrequenzinduktionsspule. Dabei kann vorgesehen sein, dass die Induktionsspule eine wassergekühlte Induktionsspule ist.

In einer Ausgestaltung der Erfindung kann vorgesehen sein, dass das Heizelement in Längsrichtung zum Bolzen bewegbar angebracht ist, wobei das Heizelement mit einem Antrieb antreibbar verbunden ist.

Dadurch kann erreicht werden, dass das Heizelement mit dem Antrieb entlang dem zu kristallisierenden Bolzen bewegt werden kann.

In einer Ausgestaltung der Erfindung kann vorgesehen sein, dass der Antrieb einen Schrittmotor und eine Antriebsschnecke aufweist, wobei der Schrittmotor mit der Antriebsschnecke verbunden ist und die Antriebsschnecke mit dem Heizelement verbunden ist.

Dadurch kann eine besonders genaue Positionierung des Heizelements in der Längsrichtung des zu kristallisierenden Bolzens erreicht werden.

In einer Ausgestaltung der Erfindung kann vorgesehen sein, dass die Induktionsspule mit einem Generator, insbesondere mit einem Hochfrequenzgenerator elektrisch leitend verbunden ist.

In einer Ausgestaltung der Erfindung kann vorgesehen sein, dass die Verformungseinrichtung eine Presse und eine Matrize aufweist, sowie optional eine Flussmittelzufuhr.

In einer Ausgestaltung der Erfindung kann vorgesehen sein, dass die Verformungseinrichtung eine Ziehvorrichtung aufweist.

In einer Ausgestaltung der Erfindung kann vorgesehen sein, dass die Vorrichtung zur Herstellung eines ziehfähigen Lötdrahts, insbesondere eines SnBi-Lötdrahtes zusätzlich eine Spulvorrichtung zum Aufspulen des Lötdrahtes auf eine Spule aufweist.

Die Erfindung ist nachfolgend anhand der Beispiele und Figuren weiter erläutert. Die Beispiele und Figuren zeigen mögliche Ausgestaltungen der Erfindung. Prinzipiell sind jedoch auch Kombinationen oder Abwandlungen der Ausgestaltungen im Rahmen der Erfindung möglich
Figur 1 zeigt einen im Wesentlichen einkristallinen Bolzen erhalten nach dem Bridgman-Verfahren.
Figur 2 zeigt schematisch eine Vorrichtung zum Zonenschmelzen eines Bolzens.
Figur 3 zeigt schematisch eine alternative Vorrichtung zum Zonenschmelzen eines Bolzens.

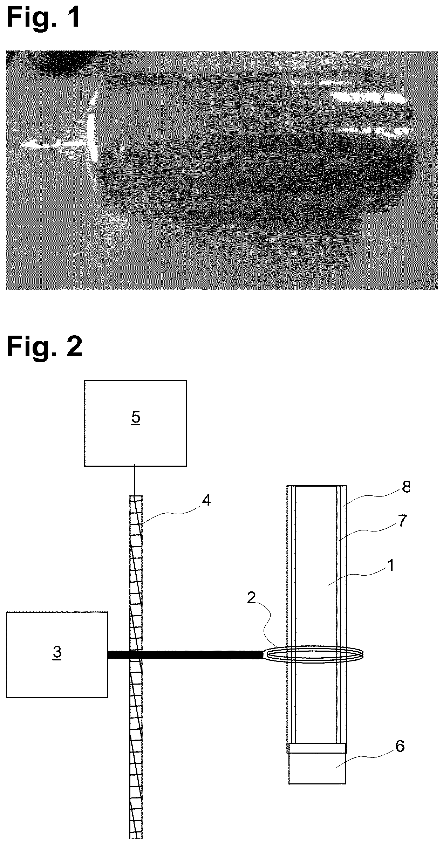

Zum Ausbilden eines im Wesentlichen einkristallinen Bolzens wurde in Beispiel 1 eine SnBi-Legierung bestehend aus 58 gew.-% Bismut und 42 gew.-% Zinn bereitgestellt, indem die Legierungsbestandteile zusammen in einem Ofen geschmolzen wurden. Eine zylindrische Borosilikat-Ampulle mit einem verjüngten Keimbereich wurde in einen Ofen mit einer Ofentemperatur am Keimbereich von 165°C gehängt. Die flüssige, geschmolzene Legierung wurde in die Ampulle gefüllt, wobei die Temperatur im Keimbereich auf 185-190°C anstieg. Anschließend wurden Dreikantstangen der gleichen Legierung in die Ampulle gegeben, wodurch die Temperatur zügig auf 145°C gesenkt wurde und die SnBi-Legierung vollständig als Schmelze vorlag. Die Ampulle wurde langsam mit steigender Geschwindigkeit mit einem Linearantrieb aus dem Ofen gefahren. Figur 1 zeigt den daraus entstandenen einkristallinen Bolzen, der aus der Ampulle herausgelöst wurde. Der so erhaltene Bolzen ließ sich gut weiter zu einem Lötdraht verarbeiten.

Zum Ausbilden eines im Wesentlichen einkristallinen Bolzens wurde in Beispiel 2 ebenfalls eine SnBi-Legierung bestehend aus 58 gew.-% Bismut und 42 gew.-% Zinn bereitgestellt, indem die Legierungsbestandteile zusammen in einem Ofen geschmolzen wurden. Aus der Legierung wurde ein Bolzen mit einem Durchmesser von 72 mm gegossen. Anschließend wurde der Bolzen durch Zonenschmelzen zu einem im Wesentlichen einkristallinen Bolzen ausgebildet. Eine schematische Darstellung der Vorrichtung zum Zonenschmelzen ist in Figur 2 dargestellt. Über den Bolzen 1 wurde ein hochtemperatur Silikonschlauch (Silikonschicht 7) mit einem Innendurchmesser von 70 mm gezogen. Der Bolzen 1 wurde in ein Glasrohr (Glasschicht 8) eingeführt und auf ein Kühlelement 6 aus Aluminium gestellt. Eine Induktionsspule 2 wurde über das Glasrohr 8 an die unterste Stelle des Bolzens 1 gefahren. Dafür wurde ein Schrittmotor 5 mit Antriebsschnecke 4 verwendet. An die Induktionsspule 2 wurde mit einem Generator 3 ein Strom mit Wechselspannung einer Frequenz von 300 kHz angelegt und die Induktionsspule 2 wurde mit dem Schrittmotor 5 über die Antriebsschnecke 4 kontinuierliche entlang der Längsrichtung des Bolzens 1 nach oben gefahren. Anschließend wurde der nun im Wesentlichen einkristalline Bolzen aus dem Glasrohr 8 entfernt und von dem Silikonschlauch 7 mit Druckluft und Wasser getrennt. Der so erhaltene Bolzen ließ sich ebenfalls gut weiter zu einem Lötdraht verarbeiten.

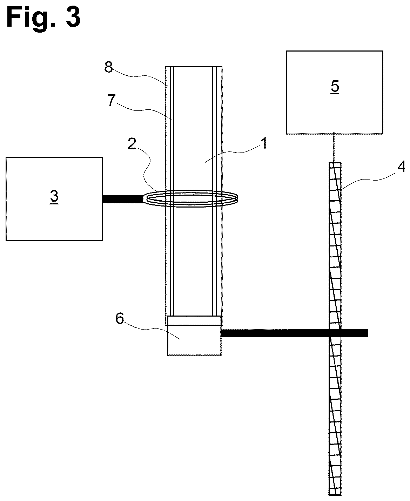

Eine alternative Ausgestaltung der Vorrichtung zum Zonenschmelzen ist in Figur 3 dargestellt. Diese Vorrichtung unterscheidet sich von der Vorrichtung aus Figur 2 dadurch, dass der Bolzen 1 mit Silikonschicht 7, Glasschicht 8 und Kühlelement 6 mit einem Schrittmotor 5 mit Antriebsschnecke 4 von unten durch die Induktionsspule 2 in eine Ausgansposition gefahren wird, wobei sich in der Ausgansposition die Induktionsspule 2 an der untersten Stelle des Bolzens befindet. Die Induktionsspule 2 ist dabei im Vergleich zu der Vorrichtung aus Figur 2 nicht mit der Antriebsschnecke 4 verbunden. Beim Zonenschmelzen wird der Bolzen 1 mit Silikonschicht 7, Glasschicht 8 und Kühlelement 6 kontinuierlich ausgehend von der Ausgangsposition entlang der Längsrichtung des Bolzens nach unten gefahren.

In Beispiel 3 wurden aus den Bolzen der Beispiele 1 und 2 mit einer Presse bei einer Vorkammertemperatur von 75°C Drähte mit und ohne Flussmittelseele gepresst. Der Pressvorgang wurde mit einer Bolzengeschwindigkeit von 0,3 mm/s gestartet und auf 0,6 mm/s angehoben Bei Flussmittelgefüllten Drähten wurde die Flussmittelvorlage auf 128-129°C bei einem Druck von 2,0-2,2 bar eingestellt. Die Matrize der Presse wurde gekühlt.

Die Drähte wurden in einem anschließenden Schritt gezogen zu einem Durchmesser von 1 mm, 1,5 mm und 2 mm. Dafür wurden die Drähte in Öl bei 70°C durch einen Ziehstein gezogen. Der Draht konnten dabei auch vorgewalzt werden. Dabei musste der Draht ebenfalls erwärmt werden. Zwischen jedem oder jedem zweiten Vorgang wurde der Draht "beruhigt", d.h. in der Wärme aufgespult und liegengelassen. Bei Massivdrähten wurde der Draht bis kurz vor Endmaß gepresst und auf Endmaß gezogen. Die Ziehgeschwindigkeit war etwas geringer als bei den üblichen bleifreien Lötdrähten, konnte aber ohne Brechen oder Reißen durchgeführt werden. Zum Entfernen des Öls wurde der Draht durch einen Stein mit gleichem Durchmesser ohne Schmierung gezogen werden.

### Bezugszeichen:

1 Bolzen
2 ringförmige Heizvorrichtung
3 Generator
4 Schnecke
5 Schrittmotor
6 Kühlvorrichtung
7 Silikonschicht
8 Glasschicht

## Patentansprüche

1. Verfahren zur Herstellung eines ziehfähigen Lötdrahtes, insbesondere eines SnBi-Lötdrahtes, wobei das Verfahren die folgenden Schritte aufweist:
a. Bereitstellen einer Lot-Legierung, insbesondere einer SnBi-Legierung
b. Ausbilden eines im Wesentlichen einkristallinen Bolzens aus der Lot-Legierung, wobei die Lot-Legierung zumindest teilweise geschmolzen und wieder kristallisiert wird
c. Ausbilden eines Lötdrahtes aus dem im Wesentlichen einkristallinen Bolzen.

2. Verfahren nach Anspruch 1, wobei die SnBi-Legierung bezogen auf die Masse der SnBi-Legierung besteht aus:
- Bismut in einem Bereich von ≥ 31 gew.-% bis ≤ 59 gew.-%, vorzugsweise ≥ 57 gew.-% bis ≤ 59 gew.-%,
- optional einem Minderelementzusatz ausgewählt aus der Gruppe bestehend aus Silber, Kupfer, Zink, Nickel, Germanium und Mischungen davon in einem Bereich von ≥ 0 gew.-% bis ≤ 3,5 gew.-%, vorzugsweise ≥ 0 gew.-% bis ≤ 1,5 gew.-%, insbesondere ≥ 0,3 gew.-% bis ≤ 1,1 gew.-%,
- und dem Rest Zinn.

3. Verfahren nach einem der vorherigen Ansprüche, wobei das Ausbilden des Lötdrahtes ein Kaltumformen des Bolzens, insbesondere ein Pressen des Bolzens durch eine Matrize, zu einem Lötdraht umfasst.

4. Verfahren nach Anspruch 3, wobei das Kaltumformen des Bolzens, insbesondere das Pressen des Bolzens durch eine Matrize, das Bereitstellen eines Flussmittels und das Ausbilden von einem Lötdraht aufweisend zumindest eine Flussmittelseele umfasst.

5. Verfahren nach einem der Ansprüche 1 bis 4, wobei das Ausbilden des Lötdrahtes ein Ziehen zu einem Lötdraht umfasst.

6. Verfahren nach einem der vorherigen Ansprüche, wobei das Ausbilden des im Wesentlichen einkristallinen Bolzens ein vollständiges Aufschmelzen der SnBi-Legierung zu einer Schmelze umfasst und der im Wesentlichen einkristalline Bolzen durch Kristallisation der Schmelze ausgebildet wird.

7. Verfahren nach Anspruch 6, wobei die Schmelze in einem Tiegel vorliegt, wobei der Tiegel einen zylindrischen Wachstumsbereich aufweist und der Tiegel an einem Ende des zylindrischen Wachstumsbereiches einen verjüngten Keimbereich aufweist, wobei in einem ersten Schritt die Schmelze im Keimbereich unter die Schmelztemperatur gebracht wird, wobei ein Kristallisationskeim im Keimbereich ausgebildet wird, und in einem zweiten Schritt der Wachstumsbereich graduell ausgehend vom Keimbereich unter die Schmelztemperatur gebracht wird, wobei der Kristallisationskeim in den Wachstumsbereich wächst und den im Wesentlichen einkristallinen Bolzen ausbildet.

8. Verfahren nach einem der vorherigen Ansprüche, wobei die SnBi-Legierung als Bolzen bereitgestellt wird und das Ausbilden des im Wesentlichen einkristallinen Bolzens ein Zonenschmelzen des Bolzens unter Ausbildung des im Wesentlichen einkristallinen Bolzens umfasst.

9. Verfahren nach Anspruch 8, wobei beim Zonenschmelzen der Bolzen entlang seiner Längsachse relativ zu einer den Bolzen orthogonal zur Längsrichtung umgebenen ringförmigen Heizvorrichtung bewegt wird, wobei der Bolzen in einer durch die ringförmige Heizvorrichtung umgebenen Schmelzzone zumindest teilweise geschmolzen wird und durch relative Bewegung zur Heizvorrichtung außerhalb der Schmelzzone unter Ausbildung des im Wesentlichen einkristallinen Bolzens wieder kristallisiert wird.

10. Verfahren nach Anspruch 9, wobei der Bolzen beim Zonenschmelzen zusätzlich gekühlt wird.

11. Verfahren nach einem der Ansprüche 9 oder 10, wobei die ringförmige Heizvorrichtung eine mit Wechselstrom betriebene Induktionsspule umfasst, wobei die Induktionsspule vorzugsweise mit einem Wechselstrom mit einer Frequenz im Bereich von größer oder gleich 250 kHz bis kleiner oder gleich 350 kHz, vorzugsweise von größer oder gleich 280 kHz bis kleiner oder gleich 320 kHz, beispielsweise 300 kHz, betrieben wird.

12. Ziehfähiger Lötdraht, insbesondere SnBi-Lötdraht hergestellt nach dem Verfahren nach einem der Ansprüche 1 bis 11.

13. Ziehfähiger Lötdraht nach Anspruch 12, wobei der Lötdraht zumindest eine Flussmittelseele aufweist.

14. Ziehfähiger Lötdraht nach einem der Ansprüche 12 oder 13, wobei der Lötdraht einen Durchmesser aufweist in einem Bereich von kleiner oder gleich 1,5 mm bis größer oder gleich 0,2 mm, vorzugsweise von kleiner oder gleich 1,0 mm bis größer oder gleich 0,4 mm, besonders bevorzugt von kleiner oder gleich 0,8 mm bis größer oder gleich 0,5 mm.

15. Vorrichtung zur Durchführung des Verfahrens nach einem der Ansprüche 1 bis 11, wobei die Vorrichtung eine Kristallisiervorrichtung und eine Verformungsvorrichtung aufweist.
